# EUROPEAN PATENT SPECIFICATION

(11) **EP 4 585 949 B1**
(45) Date of publication and mention of the grant of the patent: **28.10.2026**
(21) Application number: 23888904.2
(22) Date of filing: 15.09.2023
(51) Int. Cl.: G01R 31/389, G01R 31/392, G01R 31/385, G01R 31/396, G01R 15/04, G01R 31/52, G01R 31/54

(54) **BATTERY DIAGNOSTIC DEVICE AND METHOD**
VORRICHTUNG UND VERFAHREN ZUR BATTERIEDIAGNOSE
APPAREIL ET PROCÉDÉ DE DIAGNOSTIC DE BATTERIE

(30) Priority: 07.11.2022 KR 20220147410
(43) Date of publication of application: 16.07.2025
(73) Proprietor: LG Energy Solution, Ltd., Seoul 07335 (KR)
(72) Inventor: KIM, Jeong Wan, Daejeon 34122 (KR)
(74) Representative: Goddar, Heinz J.
(86) International application number: PCT/KR2023/013973
(87) International publication number: WO 2024/101639

(56) References cited:
- CN-A- 113 138 350
- JP-A- 2005 195 604
- JP-A- 2022 080 182
- KR-A- 20140 013 759
- KR-A- 20170 141 035
- KR-A- 20170 141 035
- KR-A- 20220 054 127
- KR-A- 20220 060 814
- US-A1- 2019 271 747
- US-B2- 11 422 102

## Description

### TECHNICAL FIELD

This application claims the benefit of Korean Patent Application No. 10-2022-0147410, filed on November 7, 2022, in the Korean Intellectual Property Office.

The present invention relates to a diagnostic device and diagnostic method for a battery, and more particularly, to a battery diagnostic device and method capable of diagnosing an assembly state.

### BACKGROUND ART

Recently, as the demand for portable electronic products such as laptops, video cameras, and portable phones has increased rapidly, and the development of electric vehicles, energy storage batteries, robots, and satellites has begun in earnest, much research is being conducted on secondary batteries used as driving power sources therefor.

A battery module may be formed by electrically connecting a plurality of battery cells. If a plurality of battery cells in a battery module are not properly connected due to poor assembly, the performance and stability of the battery module may deteriorate.

Therefore, recently, there has been a demand for a way for diagnosing a battery module to determine whether there is an assembly abnormality of the battery module.

CN 113138350 A discloses embodiments that relate to a multi-cell AC impedance measurement system. A method for measuring a complex impedance of a plurality of battery cells in a battery pack comprises controlling an excitation current through the plurality of battery cells in the battery pack; receiving, in a single common measurement circuit, a plurality of voltage signals corresponding to the plurality of battery cells; measuring the excitation current; and calculating a complex impedance of each of the battery cells in the plurality of battery cells based on the plurality of voltage signals and the measured excitation current in a single measurement cycle using either one analog-to-digital converter (ADC) per battery cell or two matched ADCs per battery cell.

US 11,422,102 B2 discloses: An in-line rapid impedance measurement device and methods of performing in-line rapid impedance spectroscopy including a switch network operable under a switching algorithm useful to rapidly perform targeted impedance measurements to assess state of health, defect or failure of battery packs or modules having a plurality of electrochemical cells interconnected in series or parallel and to isolate individual cells within a pack or module to distinguish between non-repeatable anomalous impedance measurements from repeatable deviant impedance measurements and identify the source of deviant impedance measurements.

### DISCLOSURE OF THE INVENTION

### TECHNICAL PROBLEM

Embodiments of the present invention are to provide a battery diagnostic device and method capable of diagnosing an assembly state.

The technical aspects of the present invention are not limited to the technical aspects mentioned above, and other technical aspects not mentioned will be clearly understood by those skilled in the art from the description below.

### TECHNICAL SOLUTION

The invention is set out in the appended claims. A diagnostic device for inspecting an assembly state of a battery module including at least one component and a plurality of battery cells according to an embodiment of the present invention may include: a measurement unit which measures cell impedances of the plurality of battery cells, a fixed impedance of the at least one component, and a first module impedance of the battery module; and a control unit which determines an assembly state of the battery module on the basis of the cell impedances, fixed impedance, and first module impedance.

The control unit calculates a second module impedance by adding up the cell impedances and adding the fixed impedance to the sum therefrom, and compares the first module impedance and the second module impedance to determine an assembly state of the battery module.

The control unit determines that an assembled state of the battery module is good if a difference between the first module impedance and the second module impedance is within a threshold, and determines that an assembled state of the battery module is defective if a difference between the first module impedance and the second module impedance exceeds a threshold.

According to an embodiment, the measurement unit may include: a cell measurement unit which measures the respective cell impedances for the plurality of battery cells; and a module measurement unit which measures the first module impedance of the battery module.

According to an embodiment, the module measurement unit may have a higher measurable voltage range than the cell measurement unit.

According to an embodiment, the module measurement unit may have the same measurable voltage range as the cell measurement unit.

According to an embodiment, the diagnostic device may further include a voltage distribution circuit which electrically connects the module measurement unit and the battery module and includes a plurality of resistors.

According to an embodiment, the voltage distribution circuit may distribute a voltage input from the battery module according to a resistance ratio of the plurality of resistors and supply a generated module voltage to the module measurement unit.

According to an embodiment, the diagnostic device may further include a memory in which the fixed impedance is stored, wherein the first module impedance and the cell impedances may vary with a frequency, and the fixed impedance may have a fixed value that does not change with a frequency.

According to an embodiment, the cell measurement unit may initially charge and activate the plurality of battery cells, and then measures the cell impedances at a time point after a first time elapsed, and the module measurement unit, after the activation, may measure the first module impedance at a time point after a second time elapsed.

According to an embodiment, the cell measurement unit may measure a direct current internal resistance (DCIR) of the plurality of battery modules, and then measures the cell impedances at a time point after a first period elapsed, and the module measurement unit, after measuring the direct current internal resistance (DCIR), may measure the first module impedance at a time point after a second period elapsed.

According to an embodiment, the first period may be the same period as the second period.

A diagnostic method for diagnosing an assembly state of a battery module including at least one component and a plurality of battery cells according to an embodiment of the present invention may include: measuring cell impedances of the plurality of battery cells, a fixed impedance of the at least one component, and a first module impedance of the battery module; and determining an assembly state of the battery module on the basis of the cell impedances, fixed impedance, and first module impedance.

### ADVANTAGEOUS EFFECTS

According to an embodiment of the present invention, an assembly state of a battery module may be determined based on cell impedances of a plurality of battery cells, a fixed impedance of at least one component, and a first module impedance of the battery module. Accordingly, it is possible to determine whether there is a defect in the assembly of a battery cell or a defect in the assembly of a battery module, and thus to take appropriate measures, thereby improving safety.

In addition, various effects that are directly or indirectly identified through this document may be provided.

### BRIEF DESCRIPTION OF THE DRAWINGS

FIG. 1 is a block diagram showing a diagnostic device of a battery according to a first embodiment of the present invention.
FIG. 2 is a block diagram showing another example of a measurement unit shown in FIG. 1.
FIG. 3 is a graph showing a cell impedance measured through a cell measurement unit shown in FIG. 1.
FIG. 4 is a graph showing a first module impedance measured through a module measurement unit shown in FIG. 1.
FIG. 5 is a flowchart showing a battery diagnosis method according to a first embodiment of the present invention.
FIG. 6 is a block diagram showing a diagnostic device of a battery according to a second embodiment of the present invention.

### MODE FOR CARRYING OUT THE INVENTION

Hereinafter, with reference to the accompanying drawings, preferred embodiments of the present invention will be described in detail so that those skilled in the art can easily implement the present invention. However, the present invention may be implemented in various different forms and is not limited or restricted by the following embodiments.

In order to clearly explain the present invention, detailed descriptions of parts unrelated to the description or related known technologies that may unnecessarily obscure the scope of the present invention have been omitted, and in adding reference numerals to components in each drawing in this specification, identical or similar reference numerals are used for identical or similar components throughout the specification.

In addition, terms and words used in this specification and claims should not be construed as limited to their usual or dictionary meanings, but should be interpreted as meanings and concepts consistent with the technical idea of the present invention on the basis of the principle that an inventor can appropriately define the concept of a term in order to explain his or her invention in the best way possible.

### Diagnostic device according to first embodiment

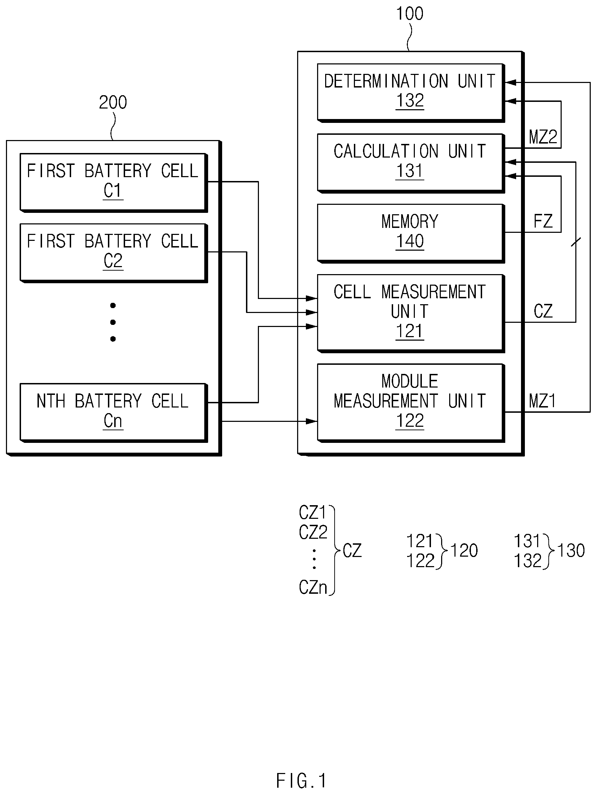

FIG. 1 is a block diagram showing a diagnostic device of a battery according to a first embodiment of the present invention.

Referring to FIG. 1, a diagnostic device 100 is configured to diagnose an assembly state of a battery module 200 after an assembly process of the battery module 200.

The battery module 200 includes a plurality of battery cells C1, C2, ... , Cn and at least one component. Each of the plurality of battery cells C1, C2, ... , Cn has a negative terminal and a positive terminal and refers to an independent physically separable cell. The plurality of battery cells C1, C2, ... , Cn included in the battery module 200 may be connected in series and/or parallel.

The diagnostic device 100 measures impedances of each of the battery cells C1, C2, ... , Cn and the battery module 200 and detects assembly defects in the battery module on the basis of the measured impedances. The diagnostic device 100 may supply an electrical signal to the assembled battery module 200, and then, after a predetermined time has elapsed, measure impedances of each of the battery cells C1, C2, ... , Cn and the battery module 200. As an example, the diagnostic device 100 may measure impedances of each of the battery cells C1, C2, ... , Cn and the battery module 200 after initially charging and activating the battery module 200. As another example, the diagnostic device 100 may measure a direct current internal resistance (DCIR) of a plurality of battery modules 20 and then measure impedances of each of the battery cells C1, C2, ... , Cn and the battery module 200.

According to an embodiment, the diagnostic device 100 may include a measurement unit 120, a control unit 130, and a memory 140.

The measurement unit 120 may include a cell measurement unit 121 and a module measurement unit 122 to measure impedances CZ, MZ1 inside the battery module 200. For example, the measurement unit 120 may measure impedances CZ, MZ1 by using electrochemical impedance spectroscopy (EIS).

The cell measurement unit 121 is configured to measure a cell impedance CZ of each of the plurality of battery cells C1, C2, ... , Cn. The cell measurement unit 121 may be configured to apply an alternating current voltage to each of the plurality of battery cells C1, C2, ... , Cn. The cell measurement unit 121 may be configured to apply alternating voltage to each of the plurality of battery cells C1, C2, ... , Cn while changing a frequency. For example, the cell measurement unit 121 may be configured to charge each of the plurality of battery cells C1, C2, ... , Cn while applying an alternating voltage to each of the plurality of battery cells C1, C2, ... , Cn, and measure cell impedances CZ1, CZ2, ... , CZn of each of the plurality of battery cells C1, C2, ... , Cn during such a charging process.

The module measurement unit 122 is configured to measure a first module impedance MZ1 of the battery module 200 including the plurality of battery cells C1, C2, ... , Cn. The module measurement unit 122 may be configured to apply an alternating voltage to the battery module 200. The module measurement unit 122 may be configured to apply an alternating voltage to the battery module 200 while changing a frequency. For example, the module measurement unit 122 may be configured to charge the battery module 200 while applying an alternating voltage to the battery module 200, and measure a first module impedance MZ1 of the battery module 200 in such a charging process.

The module measurement unit 122 may have a higher measurable voltage range than the cell measurement unit 121. Since a module voltage of the battery module 200 input to the module measurement unit 122 is higher than a cell voltage of the battery cells C1, C2, ... Cn input to the cell measurement unit 121, a measurable voltage range of the module measurement unit 122 may be set high. For example, the cell measurement unit 121 may measure a cell impedance, which is a low-voltage alternating current impedance of less than 5 V. The module measurement unit 122 may measure a first module impedance MZ1, which is a high-voltage alternating current impedance of 1000 V or less.

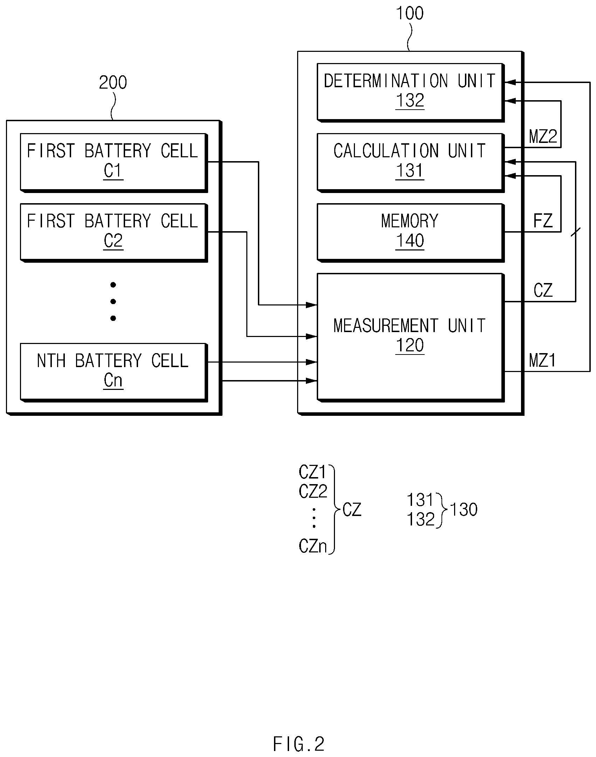

As an example, in the measurement unit 120, the cell measurement unit 121 and the module measurement unit 122 may be individually configured, as shown in FIG. 1. As another example, the measurement unit 120 may be composed as one including only a module measurement unit, omitting a cell measurement unit, as shown in FIG. 2. The measurement unit 120 shown in FIG. 2 may have a high measurable voltage range identically to the module measurement unit shown in FIG. 1. Accordingly, the measurement unit 120 shown in FIG. 2 measures not only a first module impedance MZ1 but also a cell impedance CZ.

The memory 140 may store a fixed impedance FZ.
The fixed impedance FZ is an impedance of at least one component in the battery module 200 excluding the plurality of battery cells C1, C2, ... , Cn. For example, a fixed impedance FZ may be calculated as the sum of impedances of all components in the battery module 200 excluding the plurality of battery cells C1, C2, ... , Cn. The fixed impedance FZ has a fixed value that does not vary with a frequency. The fixed impedance FZ may be a value obtained in advance through a prior measurement before measuring at least one of cell impedances CZ and a first module impedance MZ1.

The control unit 130 determines an assembly state of the battery module 200 on the basis of cell impedances CZ, a first module impedance MZ1, and a fixed impedance FZ. The control unit 130 may be connected to the measurement unit 120 and the memory 140 to be able to communicate therewith in a wired manner and/or wirelessly.

The control unit 130 may include a calculation unit 131 and a determination unit 132. The calculation unit 131 and the determination unit 132 may be integrated into one component (e.g., a single chip) or may be implemented as a plurality of separate components (e.g., multiple chips).

The calculation unit 131 may receive cell impedances CZ from the cell measurement unit 121, a first module impedance MZ1 from the module measurement unit 122, and a fixed impedance FZ from the memory 140. The calculation unit 131 calculates a second module impedance MZ2 on the basis of received impedances CZ, MZ1, FZ.

The calculation unit 131 sums cell impedances CZ1, CZ2, ... , CZn of the plurality of battery cells C1, C2, ... ,Cn, respectively, as shown in Equation 1, and calculates a second module impedance MZ2 by adding a fixed impedance FZ to a summed value. [Equation 1] $MZ 2 = FZ + {\sum }_{i = 1}^{n} {CZ}_{i}$

The determination unit 132 detects assembly defects of the battery module 200 by comparing a calculated second module impedance MZ2 with a first module impedance MZ1 measured through the module measurement unit 122.

The determination unit 132 compares a first module impedance MZ1 and a second module impedance MZ2 to determine if a difference between the first module impedance MZ1 and the second module impedance MZ2 is within a threshold (e.g., error range). If a difference between a first module impedance MZ1 and a second module impedance MZ2 is within a threshold, the determination unit 132 determines that no assembly defect has occurred in the battery module 200 and determines the battery module 200 as a good product. When a difference between a first module impedance MZ1 and a second module impedance MZ2 exceeds a threshold, the determination unit 132 determines that an assembly defect has occurred in the battery module 200 and determines that the battery module 200 is defective.

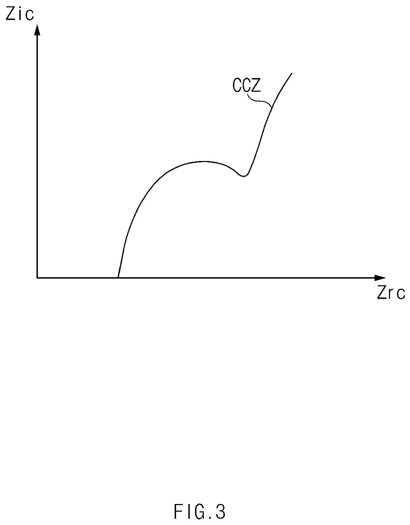

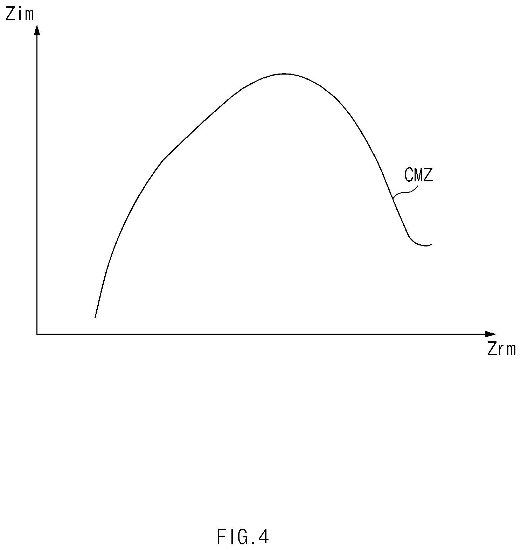

FIG. 3 is a graph showing a cell impedance measured through a cell measurement unit shown in FIG. 1, and FIG. 4 is a graph showing a first module impedance measured through a module measurement unit shown in FIG. 1. In FIG. 3, a horizontal axis may be said to be a real component Zrc of a cell impedance, and a vertical axis may be said to be an imaginary component Zic of a cell impedance. In FIG. 4, a horizontal axis may be said to be a real component Zrm of a first module impedance, and a vertical axis may be said to be an imaginary component Zim of a first module impedance. In FIGS. 3 and 4, the units of horizontal and vertical axes may be mΩ or Ω.

As shown in FIG. 3, a cell impedance may vary depending on a frequency of an alternating current signal applied to each of the plurality of battery cells C1, C2, ... , Cn. As a frequency changes, a real component Zrc and an imaginary component Zic of a cell impedance change, and an intersection point thereof is displayed as an impedance point, which is a point on the coordinates, so as to derive a cell impedance curve CCZ. A cell impedance of each of the plurality of battery cells C1, C2, ... , Cn may derive the cell impedance curve CCZ or cell impedance curves, at least one of which is different from the others.

The first module impedance may vary depending on a frequency of an alternating current signal applied to the battery module 200, as shown in FIG. 4. As a frequency changes, a real component Zrm and an imaginary component Zim of a first module impedance change, and an intersection point thereof is displayed as an impedance point, which is a point on the coordinates, so as to derive a first module impedance curve CMZ.

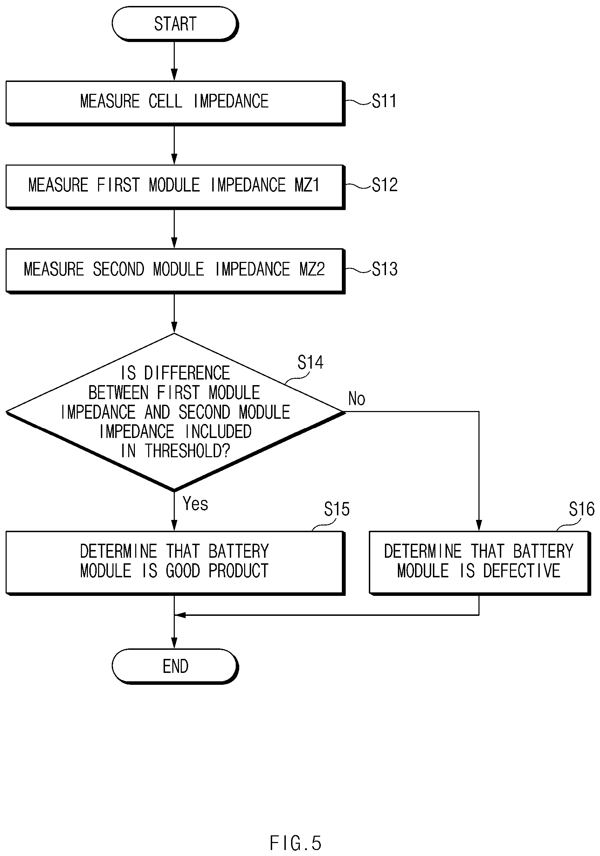

FIG. 5 is a flowchart showing a battery diagnosis method according to a first embodiment of the present invention.

In operation S11, a cell measurement unit (e.g., cell measurement unit 121 in FIG. 1) measures a cell impedance (e.g., cell impedance CZ in FIG. 1) of each of a plurality of battery cells (e.g., battery cells C1, C2, ... , Cn in FIG. 1) within minutes. For example, the cell measurement unit may quickly measure cell impedances within 1 to 3 minutes by using an EIS measurement scheme. The measured cell impedances may be stored in a memory (e.g., memory 140 in FIG. 2) or transmitted to a control unit (e.g., control unit 130 in FIG. 1).

As an example, a cell impedance may be measured at a time point after a first predetermined period elapsed after activating each of the plurality of battery cells. Meanwhile, after a battery cell in a discharged state is assembled, the battery cell may be activated through primary charging.

As another example, a cell impedance may be measured at a time point after a first predetermined period elapsed after measuring a direct current internal resistance (DCIR) of each of the plurality of battery cells.

In operation S12, a module measurement unit (e.g., module measurement unit 122 in FIG. 1) measures a first module impedance MZ1 of a battery module assembled to include at least one component and a plurality of battery cells within minutes. For example, the module measurement unit may quickly measure module impedances within 1 to 3 minutes by using an EIS measurement scheme. The measured module impedances may be transmitted to a control unit.

As an example, a first module impedance MZ1 may be measured at a time point after a second predetermined period elapsed after activating the battery module. The second period may be the same as the first period. Meanwhile, after a battery module in a discharged state is assembled, the battery module may be activated through initial charging.

As another example, a first module impedance MZ1 may be measured at a time point after a predetermined second period elapsed after measuring a direct current internal resistance (DCIR) of the battery module. The second period may be the same as the first period. The first period and the second period may be seconds to minutes. For example, the first period and the second period may be 30 seconds.

In operation S13, a control unit calculates a second module impedance MZ2 by adding measured cell impedances and a fixed impedance stored in a memory. A fixed impedance may be an impedance of at least one component included in a battery module. At least one component may be a component other than a plurality of battery cells included in the battery module.

In operation S14, a control unit compares a measured first module impedance MZ1 and a calculated second module impedance MZ2. The control unit determines whether a difference between a measured first module impedance MZ1 and a calculated second module impedance MZ2 is included in a threshold.

In operation S15, if a difference between a first module impedance MZ1 and a second module impedance MZ2 is within a preset threshold as a result of comparison, a control unit determines that there is no assembly defect in a battery module. Accordingly, the control unit may determine that the battery module is a good product.

In operation S16, if a difference between a first module impedance MZ1 and a second module impedance MZ2 is out of (or exceeds) a threshold as a result of comparison, a control unit determines that there is an assembly defect in a battery module. Accordingly, a control unit determines that the battery module is defective.

According to an embodiment, a cell impedance and a first module impedance MZ1 may be measured separately as described above. For example, a cell impedance may be measured after placing a plurality of battery cells. Then, after a battery module is formed by assembling a plurality of battery cells and at least one component, a first module impedance MZ1 may be measured.

According to an embodiment, a cell impedance and a first module impedance MZ1 may be measured simultaneously. A cell impedance and a first module impedance MZ1 may be measured after a battery module is formed by assembling a plurality of battery cells and at least one component.

### Diagnostic device according to second embodiment

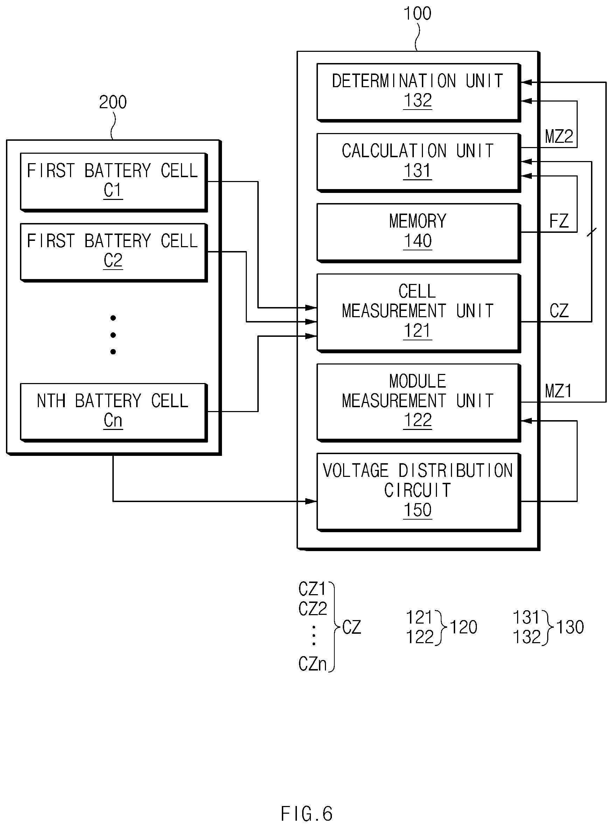

FIG. 6 is a block diagram showing a diagnostic device of a battery according to a second embodiment of the present invention.

Referring to FIG. 6, the diagnostic device according to the second embodiment of the present invention has the same components as the diagnostic device shown in FIG. 1, except that the former further includes a voltage distribution circuit 150. Accordingly, the previous description may apply to the same configuration and/or operation among configurations and/or operations of the diagnostic device described above.

A module measurement unit 122 may have a measurable voltage range that is the same or similar to that of a cell measurement unit 121. A measurable voltage range of the module measurement unit 122 may be the same or similar to cell voltages of a plurality of battery cells C1, C2, ... , Cn. It is difficult to measure a module impedance of a battery module 200, which has a module voltage higher than a cell voltage of the battery cells C1, C2, ... , Cn, through the module measurement unit 122. Accordingly, an adjusted voltage dropped through the voltage distribution circuit 150 connected to the front end of the module measurement unit 122 may be transmitted to the module measurement unit 122. Between the battery module 200 and the module measurement unit 122, the voltage distribution circuit 150 may be electrically connected thereto.

The voltage distribution circuit 150 may be formed to include a plurality of resistors and to have a resistance ratio that distributes a module voltage of the battery module 200. The voltage distribution circuit 150 may lower a module voltage to an adjustment voltage measurable by the module measurement unit 122 according to a resistance ratio of the plurality of resistors.

A resistance ratio of the plurality of resistors may be a value obtained in advance through a prior measurement before the diagnostic device is executed (before measuring a cell impedance). A resistance ratio may be set through a plurality of prior measurements so that a difference between the first module impedance (MZ1) and the second module impedance (MZ2) is included within a threshold. For example, a resistance ratio may be set so that a first module impedance MZ1 and a second module impedance MZ2 have the same value.

The module measurement unit 122 may measure a first module impedance by using an adjusted voltage dropped through a voltage distribution circuit. Even if an adjusted voltage dropped is input through a voltage distribution circuit, the module measurement unit 122 may recognize the voltage as a module voltage before a voltage drop and derive a first module impedance MZ1 corresponding to the module voltage.

The battery diagnostic device according to the present invention described above may be applied to a battery pack. A battery pack according to the present invention, in addition to the above-described diagnostic device, may further include components typically included in a battery pack, such as one or more secondary batteries, a battery management system (BMS), a current sensor, a relay, a fuse, a pack case, and the like. A plurality of battery cells and a plurality of battery modules included in the battery pack may be targeted by the diagnostic device. At least some functions or operations of a control unit and a memory included in the diagnostic device may be implemented by a BMS.

The above-described battery pack may be applied to various devices. The battery pack may be applied to transportations such as electric bicycles, electric vehicles, and hybrids, but is not limited thereto and may be applied to various devices in which battery packs are usable.

The above-described diagnostic device and method are not limited to the embodiments described in each drawing, and may be implemented in various different forms. As an example, the diagnostic device may be applied to an inspection process before product shipment. As another example, the diagnostic device may be applied to an inspection process after product shipment. A defective connection weakened due to long-term use of battery packs applied to various devices may be diagnosed.

The above-described diagnostic device and method are not limited to the embodiments described in each drawing, and the structures described in each drawing may be applied in combination. As an example, the diagnostic device and method according to the present invention may measure a cell impedance and a first module impedance after activation or direct current internal resistance measurement as described above. As another example, the diagnostic device and method according to the present invention may measure a cell impedance and a first module impedance after activation, and remeasure a cell impedance and a first module impedance after measuring direct current internal resistance.

Although the present invention has been described above with limited examples and drawings, the present invention is not limited thereto, and various implementations can be made by those skilled in the art to which the present invention pertains, within the scope of equivalency of the technical idea of the present invention and the scope of the claims described below.

### [Description of reference numerals]

- 100:: Diagnostic device
- 120:: Measurement unit
- 121:: Cell measurement unit
- 122:: Module measurement unit
- 130:: control unit
- 131:: Calculation unit
- 132:: Determination unit

## Claims

1. A diagnostic device (100) for inspecting an assembly state of a battery module (20, 200) including at least one component and a plurality of battery cells, the diagnostic device (100) comprising:
a measurement unit (120) configured to measure cell impedances of the plurality of battery cells, a fixed impedance of the at least one component, and a first module impedance of the battery module (20, 200); and
a control unit (130) configured to determine an assembly state of the battery module (20, 200) on the basis of the cell impedances, fixed impedance, and first module impedance,
**characterised in that**
the control unit (130) is configured to calculate a second module impedance by adding up the cell impedances and adding the fixed impedance to the sum therefrom, and to compare the first module impedance and the second module impedance to determine an assembly state of the battery module (20, 200),
wherein the control unit (130) is configured to determine that an assembled state of the battery module (20, 200) is good if a difference between the first module impedance and the second module impedance is within a threshold, and to determine that an assembled state of the battery module (20, 200) is defective if a difference between the first module impedance and the second module impedance exceeds a threshold.

2. The diagnostic device (100) of claim 1, wherein the measurement unit (120) comprises:
a cell measurement unit (121) configured to measure the respective cell impedances for the plurality of battery cells; and
a module measurement unit (122) configured to measure the first module impedance of the battery module (20, 200).

3. The diagnostic device (100) of claim 2, wherein the module measurement unit (122) has a higher measurable voltage range than the cell measurement unit (121).

4. The diagnostic device (100) of claim 2, wherein the module measurement unit (122) has the same measurable voltage range as the cell measurement unit (121).

5. The diagnostic device (100) of claim 4, further comprising: a voltage distribution circuit (150) which electrically connects the module measurement unit (122) and the battery module (20, 200) and includes a plurality of resistors.

6. The diagnostic device (100) of claim 5, wherein the voltage distribution circuit (150) is configured to distribute a voltage input from the battery module (20, 200) according to a resistance ratio of the plurality of resistors and to supply a generated module voltage to the module measurement unit (122).

7. The diagnostic device (100) of claim 1, further comprising a memory (140) in which the fixed impedance is stored, wherein the first module impedance and the cell impedances vary with a frequency, and the fixed impedance has a fixed value that does not change with a frequency.

8. The diagnostic device (100) of claim **2,** wherein the cell measurement unit (121) is configured to initially charge and activate the plurality of battery cells, and is configured to then measure the cell impedances at a time point after a first time elapsed, and the module measurement unit (122) is configured to measure, after the activation, the first module impedance at a time point after a second time elapsed.

9. The diagnostic device (100) of claim 2, wherein the cell measurement unit (121) is configured to measure a direct current internal resistance, DCIR, of the plurality of battery cells, and is configured to then measure the cell impedances at a time point after a first period elapsed, and the module measurement unit (122) is configured to, after measuring the direct current internal resistance, DCIR, measure the first module impedance at a time point after a second period elapsed.

10. The diagnostic device (100) of claim 8 or **9,** wherein the first period is the same period as the second period.

11. A diagnostic method for diagnosing an assembly state of a battery module (20, 200) including at least one component and a plurality of battery cells, the method comprising:
measuring cell impedances of the plurality of battery cells, a fixed impedance of the at least one component, and a first module impedance of the battery module (20, 200);
calculating a second module impedance by adding up the cell impedances and adding the fixed impedance to the sum therefrom, and compares the first module impedance and the second module impedance to determine an assembly state of the battery module (20, 200)
determining an assembly state of the battery module (20, 200) on the basis of the cell impedances, fixed impedance, and first module impedance by determining that an assembled state of the battery module (20, 200) is good if a difference between the first module impedance and the second module impedance is within a threshold, and determining that an assembled state of the battery module (20, 200) is defective if a difference between the first module impedance and the second module impedance exceeds a threshold.

## Patentansprüche

1. Diagnosevorrichtung (100) zum Prüfen eines Montagezustands eines Batteriemoduls (20, 200), das mindestens eine Komponente und eine Vielzahl von Batteriezellen beinhaltet, wobei die Diagnosevorrichtung (100) Folgendes umfasst:
eine Messeinheit (120), die konfiguriert ist, um Zellimpedanzen der Vielzahl von Batteriezellen, eine feste Impedanz der mindestens einen Komponente und eine erste Modulimpedanz des Batteriemoduls (20, 200) zu messen; und
eine Steuereinheit (130), die konfiguriert ist, um einen Montagezustand des Batteriemoduls (20, 200) auf der Basis der Zellimpedanzen, einer festen Impedanz und der ersten Modulimpedanz zu bestimmen,
**dadurch gekennzeichnet, dass** die Steuereinheit (130) konfiguriert ist, um eine zweite Modulimpedanz durch Addieren der Zellimpedanzen und Addieren der festen Impedanz zu der Summe daraus zu berechnen und die erste Modulimpedanz und die zweite Modulimpedanz zu vergleichen, um einen Montagezustand des Batteriemoduls (20, 200) zu bestimmen,
wobei die Steuereinheit (130) konfiguriert ist, um zu bestimmen, dass ein Montagezustand des Batteriemoduls (20, 200) gut ist, wenn eine Differenz zwischen der ersten Modulimpedanz und der zweiten Modulimpedanz innerhalb eines Schwellenwerts liegt, und um zu bestimmen, dass ein Montagezustand des Batteriemoduls (20, 200) fehlerhaft ist, wenn eine Differenz zwischen der ersten Modulimpedanz und der zweiten Modulimpedanz einen Schwellenwert überschreitet.

2. Diagnosevorrichtung (100) nach Anspruch 1, wobei die Messeinheit (120) umfasst:
eine Zellmesseinheit (121), die konfiguriert ist, um die jeweiligen Zellimpedanzen für die Vielzahl von Batteriezellen zu messen; und
eine Modulmesseinheit (122), die konfiguriert ist, um die erste Modulimpedanz des Batteriemoduls (20, 200) zu messen.

3. Diagnosevorrichtung (100) nach Anspruch 2, wobei die Modulmesseinheit (122) einen höheren messbaren Spannungsbereich als die Zellmesseinheit (121) aufweist.

4. Diagnosevorrichtung (100) nach Anspruch 2, wobei die Modulmesseinheit (122) den gleichen messbaren Spannungsbereich wie die Zellmesseinheit (121) aufweist.

5. Diagnosevorrichtung (100) nach Anspruch 4, ferner umfassend: eine Spannungsverteilungsschaltung (150), die die Modulmesseinheit (122) und das Batteriemodul (20, 200) elektrisch verbindet und eine Vielzahl von Widerständen beinhaltet.

6. Diagnosevorrichtung (100) nach Anspruch 5, wobei die Spannungsverteilungsschaltung (150) konfiguriert ist, um eine Spannungseingabe von dem Batteriemodul (20, 200) gemäß einem Widerstandsverhältnis der Vielzahl von Widerständen zu verteilen und eine erzeugte Modulspannung an die Modulmesseinheit (122) zu liefern.

7. Diagnosevorrichtung (100) nach Anspruch 1, ferner umfassend einen Speicher (140), in dem die feste Impedanz gespeichert ist, wobei die erste Modulimpedanz und die Zellimpedanzen mit einer Frequenz variieren und die feste Impedanz einen festen Wert aufweist, der sich nicht mit einer Frequenz ändert.

8. Diagnosevorrichtung (100) nach Anspruch 2, wobei die Zellmesseinheit (121) konfiguriert ist, um die Vielzahl von Batteriezellen anfänglich zu laden und zu aktivieren, und konfiguriert ist, um dann die Zellimpedanzen zu einem Zeitpunkt zu messen, nachdem eine erste Zeit verstrichen ist, und die Modulmesseinheit (122) konfiguriert ist, um nach der Aktivierung die erste Modulimpedanz zu einem Zeitpunkt zu messen, nachdem eine zweite Zeit verstrichen ist.

9. Diagnosevorrichtung (100) nach Anspruch 2, wobei die Zellmesseinheit (121) konfiguriert ist, um einen Gleichstrominnenwiderstand, DCIR, der Vielzahl von Batteriezellen zu messen, und konfiguriert ist, um dann die Zellimpedanzen zu einem Zeitpunkt zu messen, nachdem eine erste Periode verstrichen ist, und die Modulmesseinheit (122) konfiguriert ist, um nach dem Messen des Gleichstrominnenwiderstands, DCIR, die erste Modulimpedanz zu einem Zeitpunkt zu messen, nachdem eine zweite Periode verstrichen ist.

10. Diagnosevorrichtung (100) nach Anspruch 8 oder 9, wobei die erste Periode die gleiche Periode wie die zweite Periode ist.

11. Diagnoseverfahren zum Diagnostizieren eines Montagezustands eines Batteriemoduls (20, 200), das mindestens eine Komponente und eine Vielzahl von Batteriezellen beinhaltet, wobei das Verfahren Folgendes umfasst:
Messen von Zellimpedanzen der Vielzahl von Batteriezellen, einer festen Impedanz der mindestens einen Komponente und einer ersten Modulimpedanz des Batteriemoduls (20, 200);
Berechnen einer zweiten Modulimpedanz durch Addieren der Zellimpedanzen und Addieren der festen Impedanz zu der Summe daraus und Vergleichen der ersten Modulimpedanz und der zweiten Modulimpedanz, um einen Montagezustand des Batteriemoduls (20, 200) zu bestimmen;
Bestimmen eines Montagezustands des Batteriemoduls (20, 200) auf der Basis der Zellimpedanzen, der festen Impedanz und der ersten Modulimpedanz durch Bestimmen, dass ein Montagezustand des Batteriemoduls (20, 200) gut ist, wenn eine Differenz zwischen der ersten Modulimpedanz und der zweiten Modulimpedanz innerhalb eines Schwellenwerts liegt, und Bestimmen, dass ein Montagezustand des Batteriemoduls (20, 200) fehlerhaft ist, wenn eine Differenz zwischen der ersten Modulimpedanz und der zweiten Modulimpedanz einen Schwellenwert überschreitet.

## Revendications

1. Dispositif de diagnostic (100) servant à inspecter un état d'assemblage d'un module de batterie (20, 200) comprenant au moins un composant et une pluralité d'éléments de batterie, le dispositif de diagnostic (100) comportant :
une unité de mesure (120) configurée pour mesurer les impédances des éléments de la pluralité d'éléments de batterie, une impédance fixe dudit au moins un composant, et une première impédance de module du module de batterie (20, 200) ; et
une unité de contrôle (130) configurée pour déterminer un état d'assemblage du module de batterie (20, 200) sur la base des impédances des éléments, de l'impédance fixe et de la première impédance de module,
**caractérisé en ce que** l'unité de contrôle (130) est configurée pour calculer une deuxième impédance de module en additionnant les impédances des éléments et en ajoutant l'impédance fixe à la somme de celles-ci, et pour comparer la première impédance de module et la deuxième impédance de module afin de déterminer un état d'assemblage du module de batterie (20, 200),
dans lequel l'unité de contrôle (130) est configurée pour déterminer qu'un état assemblé du module de batterie (20, 200) est bon si une différence entre la première impédance de module et la deuxième impédance de module se situe dans les limites d'un seuil, et pour déterminer qu'un état assemblé du module de batterie (20, 200) est défectueux si une différence entre la première impédance de module et la deuxième impédance de module dépasse un seuil.

2. Dispositif de diagnostic (100) selon la revendication 1, dans lequel l'unité de mesure (120) comporte :
une unité de mesure d'élément (121) configurée pour mesurer les impédances des éléments respectifs pour la pluralité d'éléments de batterie ; et
une unité de mesure de module (122) configurée pour mesurer la première impédance de module du module de batterie (20, 200).

3. Dispositif de diagnostic (100) selon la revendication 2, dans lequel l'unité de mesure de module (122) a une plage de tension mesurable supérieure par rapport à celle de l'unité de mesure d'élément (121).

4. Dispositif de diagnostic (100) selon la revendication 2, dans lequel l'unité de mesure de module (122) a la même plage de tension mesurable que l'unité de mesure d'élément (121).

5. Dispositif de diagnostic (100) selon la revendication 4, comportant par ailleurs : un circuit de distribution de tension (150) qui connecte électriquement l'unité de mesure de module (122) et le module de batterie (20, 200) et qui comprend une pluralité de résistances.

6. Dispositif de diagnostic (100) selon la revendication 5, dans lequel le circuit de distribution de tension (150) est configuré pour distribuer une entrée en tension en provenance du module de batterie (20, 200) selon un rapport de résistance de la pluralité de résistances et pour fournir une tension de module générée à l'unité de mesure de module (122).

7. Dispositif de diagnostic (100) selon la revendication 1, comportant par ailleurs une mémoire (140) dans laquelle l'impédance fixe est stockée, dans lequel la première impédance de module et les impédances des éléments varient en fonction d'une fréquence, et l'impédance fixe a une valeur fixe qui ne change pas en fonction d'une fréquence.

8. Dispositif de diagnostic (100) selon la revendication 2, dans lequel l'unité de mesure d'élément (121) est configurée pour charger et activer initialement la pluralité d'éléments de batterie, et est configurée pour ensuite mesurer les impédances des éléments au cours d'un point dans le temps après qu'un premier temps s'est écoulé, et l'unité de mesure de module (122) est configurée pour mesurer, après l'activation, la première impédance de module au cours d'un point dans le temps après qu'un deuxième temps s'est écoulé.

9. Dispositif de diagnostic (100) selon la revendication 2, dans lequel l'unité de mesure d'élément (121) est configurée pour mesurer une résistance DCIR (direct current internal resistance - résistance interne en courant continu) de la pluralité d'éléments de batterie, et est configurée pour ensuite mesurer les impédances des éléments au cours d'un point dans le temps après qu'une première période s'est écoulée, et l'unité de mesure de module (122) est configurée pour, après avoir mesuré la résistance DCIR (direct current internal resistance - résistance interne en courant continu), mesurer la première impédance de module au cours d'un point dans le temps après qu'une deuxième période s'est écoulée.

10. Dispositif de diagnostic (100) selon la revendication 8 ou la revendication 9, dans lequel la première période est la même période que la deuxième période.

11. Procédé de diagnostic servant à diagnostiquer un état d'assemblage d'un module de batterie (20, 200) comprenant au moins un composant et une pluralité d'éléments de batterie, le procédé comportant les étapes consistant à :
mesurer les impédances des éléments de la pluralité d'éléments de batterie, une impédance fixe dudit au moins un composant, et une première impédance de module du module de batterie (20, 200) ;
calculer une deuxième impédance de module en additionnant les impédances des éléments et en ajoutant l'impédance fixe à la somme de celles-ci, et comparer la première impédance de module et la deuxième impédance de module afin de déterminer un état d'assemblage du module de batterie (20, 200) ;
déterminer un état d'assemblage du module de batterie (20, 200) sur la base des impédances des éléments, de l'impédance fixe et de la première impédance de module en déterminant qu'un état assemblé du module de batterie (20, 200) est bon si une différence entre la première impédance de module et la deuxième impédance de module se situe dans les limites d'un seuil, et déterminer qu'un état assemblé du module de batterie (20, 200) est défectueux si une différence entre la première impédance de module et la deuxième impédance de module dépasse un seuil.
